# EUROPÄISCHE PATENTANMELDUNG

(11) **EP 2 975 154 A1**
(43) Veröffentlichungstag der Anmeldung: **20.01.2016**
(21) Anmeldenummer: 14176907.5
(22) Anmeldetag: 14.07.2014
(51) Int. Cl.: C23C 14/06, C23C 14/16, G01T 3/00

(54) **Verfahren zur Herstellung von Neutronen Konvertern**

(71) Anmelder: Helmholtz-Zentrum Geesthacht Zentrum für Material- und Küstenforschung GmbH, 21502 Geesthacht (DE)
(72) Erfinder: Störmer, Michael, 21031 Hamburg (DE); Horstmann, Christian, 21502 Geesthacht (DE); Nowak, Gregor, 22117 Hamburg (DE); Kampmann, Reinhard, 21365 Adendorf (DE); Hedde, John, 21403 Wendisch-Evern (DE)
(74) Vertreter: UEXKÜLL & STOLBERG

(57) **Zusammenfassung**

Die vorliegende Erfindung betrifft ein Verfahren zur Herstellung eines Neutronenkonverters aus Borkarbid oder einem Bor-film auf einem neutronentransparenten Metallsubstrat. Das neutronentransparente Metallsubstrat wird in einem ersten Schritt durch Feinschleifen, Polieren, Strahlen mit einem geeigneten Strahlmittel (Sand, Glasperlen, und/oder Metallbeschichteten Trägerkorn),chemisches oder elektronisches Ätzen und/oder anodische Oxidation zur Herstellung der gewünschten Oberflächengüte vorbehandelt und in einem weiteren Schritt mittels Sputtern (Kathodenstrahlzerstäuben) mit Borkarbid-oder einem Bor-Film beschichtet. Gegebenenfalls wird zwischen dem Metallsubstrat und unter der Bor- oder Borkarbidschicht eine Haftvermittlerschicht aufgetragen. Die erhaltenen Beschichtungen weisen eine hohe Homogenität in Schichtdicke, chemischer Zusammensetzung und Isotopenverhältnis sowie geringe Verunreinigungen wie Sauerstoff oder Stickstoff auf.

## Beschreibung

Die vorliegende Erfindung betrifft ein Verfahren zur Herstellung von Neutronenkonvertern.

### HINTERGRUND DER ERFINDUNG

Neutronen werden heutzutage in der Grundlagenforschung und in der Charakterisierung biologischer und kondensierter Materie eingesetzt. Diese vielseitige Sonde ermöglicht, durch ihre inneren Eigenschaften zeit- und ortsaufgelöste Studien an Einkristallen, magnetischen Schichten, Polymer-Membranen insbesondere biologischen Zellen mittels Diffraktion, Reflektometrie, Kleinwinkelstreuung, Spektroskopie sowie Tomographie. Wenn die kinetische Energie der Neutronen durch Moderatoren und Selektoren auf thermische Energie gesenkt wird, dann entspricht die DeBroglie-Wellenlänge der Neutronen mit hinreichender Genauigkeit den atomaren Abständen in Festkörpern. Dadurch kann die Struktur eines Festkörpers durch Streuprozesse sehr genau untersucht werden. In niedrigen Energiebereichen ermöglichen Neutronen Rückschlüsse über interne Energiezustände des Festkörpers. Für diese Anwendung ist eine ortsaufgelöste Detektion der Neutronen notwendig.

Die üblicherweise eingesetzten Detektorsysteme nutzen das Gas ³He unter hohem Druck zum Nachweis der Neutronen. Diese haben eine hohe Nachweiseffizienz (bis zu 95%) bei einer geringen Zählratenakzeptanz. ³He-Zählrohre und sogenannte Multi-Wire Proportinal Chamber (MWPC)-³He-Gasdetektoren haben bestenfalls eine Ortsauflösung im mm-Bereich und werden für die Herstellung von homogenen und großflächigen Neutronendetektoren nur unter großem Aufwand eingesetzt. Diese Technologie ist allerdings Stand der Technik, da es bisher keine starken treibenden Kräfte zur Suche nach Alternativen gegeben hat.

Auf Grund der beschränkten Verfügbarkeit von ³He und dem wachsenden Bedarf an Neutronendetektoren ist in jüngerer Zeit die Forschung und Entwicklung von alternativen Detektormaterialien kontinuierlich gestiegen. Eine bekannte Alternative zu ³He-Gasdetektoren sind ¹⁰B-Festkörperdetektoren. Das Isotop ¹⁰B hat einen relativ großen Neutronenabsorptionsquerschitt, und damit verbunden eine Absorptionseffektivität von 70% im Vergleich zu dem des ³He-Isotops in einem breiten Energiebereich von 10⁻² bis 10⁴ eV; das entspricht einem Wellenlängenband von 0.286 nm bis 0.286 pm.

Der Einsatz von ¹⁰B-Festkörperdetektoren verspricht darüber hinaus eine Verbesserung in der Ortsauflösung der Neutronendetektion im Vergleich zum konventionellen ³He-Gasdetektor. Die ¹⁰B-Festkörperdetektoren können aus einer Unterlage (Substrat) oder einem ¹⁰B-haltigen Film bestehen.

Für die Realisierung könnten folgende Anforderungen für den Konverter (d.i. Schicht-Substrat-System) aufgestellt werden:
- eine möglichst gute Haftung des Films auf dünnen Blechen (Substrat) aus einem neutronentransparenten Material wie Aluminium oder einer Aluminiumlegierung,
- eine hohe Transmission des Substrats für thermische und kalte Neutronen,
- eine gute Stabilität des Systems im Hinblick auf Strahlenbelastung und bei mechanischer sowie thermischer Beanspruchung.

Die Beschichtungen sollten zudem eine hohe Homogenität in Schichtdicke, chemischer Zusammensetzung und Isotopenverhältnis und möglichst wenig Verunreinigungen aufweisen. Eine hohe Quanteneffizienz der Konverterschichten für den Neutronennachweis bei Einstrahlung unter kleinen Winkeln zur Oberfläche ist ein weiteres Ziel der Erfindung. Generell sollten die ¹⁰B-enthaltende Beschichtungen für Festkörperdetektoren kostengünstig herstellbar sein.

Die US 6,771,730 offenbart einen Halbleiter-Neutronenkonverter mit einer Borkarbidschicht, die das Isotop ¹⁰B enthält. Das Borkarbid wurde durch plasmagestützte, chemische Gasphasenabscheidung, kurz PECVD, auf einer Siliziumhalbleiterschicht erzeugt.

Die WO 2013/002697 A1 beschreibt ein Verfahren zur Herstellung einer Neutronenkonverterkomponente, die eine Borkarbidschicht umfasst. Bei dem Verfahren wird das Borkarbid auf ein neutronentransparentes Substrat, ebenfalls mittels plasmagestützter, chemischer Gasphasenabscheidung aufgetragen.

Die bekannten Beschichtungen erfüllen allerdings nicht in allen Punkten die oben genannten Qualitäts- oder wirtschaftlichen Anforderungen, insbesondere, wenn große Bleche beschichtet werden sollen.

Zum Beispiel wird in C. Höglund et al. J. Appl. Phys. 111, 104908 (2012) eine verbesserte Haftung durch eine Temperaturbehandlung und Beschichtung mit hoher Rate realisiert. Für die verbesserte Haftung werden eine stärkere Schichtdickenvariation und höhere Herstellungskosten in Kauf genommen.

### ZUSAMMENFASSUNG DER ERFINDUNG

Der vorliegenden Erfindung liegt die Aufgabe zu Grunde, ein Verfahren zur Herstellung von Neutronenkonvertern zur Verfügung zu stellen, welches die oben beschriebenen Anforderungen an den Konverter (Film+Substrat) erfüllt: Insbesondere eine kontinuierliche, homogene Beschichtung eines ¹⁰B-haltigen Materials im Bereich von einigen Mikrometern aufzuweisen und eine sehr gute Haftung und hervorragende thermische und mechanische Stabilität unter lang andauernder Bestrahlung zu besitzen.

Ferner ist die Aufgabe der Erfindung einen Neutronenkonverter mit diesen verbesserten Eigenschaften zur Verfügung zu stellen, was realisiert wurde, indem ein ¹⁰B-Festkörper-neutronenkonverter bestehend aus einer Unterlage (einem Substrat) und einem ¹⁰B-haltigen Film in einem Prototypdetektor erfolgreich getestet wurde.

Diese Aufgaben werden durch ein Verfahren gemäß Patentanspruch 1 und einen Neutronenkonverter gemäß Patentanspruch 12 gelöst.

Erfindungsgemäß wird ein Metallsubstrat in einem ersten Schritt durch Feinschleifen, Polieren, Strahlen mit einem geeigneten Strahlmittel (Sand, Glasperlen, oder Metallbeschichteten Trägerkorn, chemisches oder elektronisches Ätzen und/oder anodische Oxidation vorbehandelt und in einem weiteren Schritt mittels Sputtern (Kathodenstrahlzerstäuben) mit Borkarbid oder einem Borfilm beschichtet.

Das Feinschleifen und Polieren findet bevorzugt unter Verwendung von Schleifpapieren statt, kann aber auch mit Hilfe einer Polierpaste - einer Emulsion aus Metallstaub, Schleifflüssigkeit und Schleifpapierkörnern - durchgeführt werden. Beim Schleifen werden die oberen Materialschichten mit Hilfe gebundener Schleifkörner (SiC, Al₂O₃, Diamant oder CBN) abgetragen. Die Körnung des verwendeten Schleifpapiers oder der Schleifpaste liegt bevorzugt im Bereich von 800 bis 2500, wobei man bei feiner werdender Körnung von Polieren spricht. Der metallografische Polierprozess beruht wie beim Schleifen auf dem spanabhebenden Abtragseffekt der Poliermedien, jedoch ist der Abrieb um einiges geringer als beim Schleifen, da mit sehr feinen Körnungen gearbeitet wird.

Bevorzugt wird das Metallsubstrat in aufeinanderfolgenden Schritten unter Verwendung von Schleifpapieren und/oder Schleifpasten mit aufsteigend feinerer Körnung zunächst feingeschliffen und dann poliert.

Bevorzugt werden sowohl zum Feinschleifen, als auch zum Polieren SiC- oder Al₂O₃-Papiere oder -Pasten verwendet.

Bei Verwendung eines Schleifpapiers findet das Feinschleifen bevorzugt auch unter Verwendung einer Schleifflüssigkeit als Naßschleifen statt. Vorzugsweise ist die Schleifflüssigkeit aus der Gruppe bestehend aus Aceton, einem Alkohol wie Methanol, Ethanol, Propanol oder Butanol, und Wasser ausgewählt. Bevorzugt wird Ethanol oder Wasser als Schleifflüssigkeit verwendet. Auch bei Verwendung einer Polierpaste ist die Schleifflüssigkeit bevorzugt aus der Gruppe bestehend aus Aceton, einem Alkohol wie Methanol, Ethanol, Propanol oder Butanol, und Wasser ausgewählt.

Das Metallsubstrat ist neutronentransparent und wird bevorzugt aus der Gruppe bestehend aus Aluminium oder einer Aluminiumlegierung, wie einer Titan-Aluminium-Legierung ausgewählt.

Nach dem Feinschleifen und Polieren wird das polierte Metallsubstrat vorzugsweise gespült. Anschließend kann das polierte und gegebenenfalls gespülte Metallsubstrat mit einer Haftvermittlerschicht, wie einer Titanschicht beschichtet werden. Bevorzugt wird die Haftvermittlerschicht durch Sputtern (Kathodenstrahlzerstäuben) erzeugt. Allerdings erzielt die Vorbehandlung eine Haftung zwischen Konverterschicht und Metallsubstrat, die eine Haftvermittlerschicht in den meisten Fällen entbehrlich macht.

Schließlich wird das Metallsubstrat mittels Kathodenstrahlzerstäuben (engl. sputtering) mit Borkarbid oder mit Borfilm beschichtet. Als Borkarbid wird bevorzugt mit ¹⁰B angereichertes B₄C verwendet. Die Beschichtung kann ohne oder mit einem Haftvermittler wie Titan durchgeführt werden. Die Schichtdicke der Beschichtung liegt bevorzugt im Bereich von 100 nm bis 10 µm, bevorzugter 250 nm bis 5 µm, am meisten bevorzugt 500 nm bis 3 µm.

Das Sputtern sowohl der Haftvermittlerschicht als auch der Konverterschicht wird bevorzugt mit festen Magnetronsputterquellen durchgeführt, wobei die Substrate gegenüber den Kathoden bewegt werden, um eine großflächig homogene Beschichtung zu erzeugen. Vorzugsweise ist der Teilchenfluss horizontal orientiert, um Kontamination auf dem Substrat und dem Sputtertarget zu minimieren. Die Beschichtungsraten liegen vorzugsweise im Bereich von 0.1 bis 1.0 nm/s. Vorzugsweise findet die Beschichtung bei einem Argondruck statt, der so gering sein kann, wie 1 µbar. Weitere Details zu Beschichtungen und Methoden insbesondere dem Manetronsputtern finden sich in Milton Ohring, Materials Science of Thin Films, Academic Press, London 1992, auf das hier vollständig Bezug genommen wird.

Durch Anwendung des erfindungsgemäßen Verfahrens können Neutronenkonverter mit einer gleichmäßigen Beschichtungsfläche von bis zu mehreren Quadratmetern, wie im Bereich von 1 bis 100 m² hergestellt werden. Die in Versuchen hergestellten Schichten auf Metallsubstraten mit einer Beschichtungsfläche von 0,5 bis 1,0 m² wurden mittels eines speziell entwickelten Testdetektors charakterisiert. Es konnten hohe Quanteneffizienten nachgewiesen werden.

Die erhaltenen Beschichtungen weisen eine hohe Homogenität in Schichtdicke, chemischer Zusammensetzung und Isotopenverhältnis sowie geringe Verunreinigungen wie Sauerstoff oder Stickstoff auf. Überraschenderweise weisen die erfindungsgemäß hergestellten Beschichtungen eine gute Haftung auf dünnen Blechen aus Aluminium oder einer Aluminiumlegierung selbst bei großflächigen oder dicken Beschichtungen von bis zu 5 µm auf.

## Patentansprüche

1. Verfahren zur Herstellung von Neutronenkonvertern, bei dem ein neutronentransparentes Metallsubstrat in einem ersten Schritt durch Feinschleifen, Polieren, Strahlen mit einem geeigneten Strahlmittel (Sand, Glasperlen, oder Metallbeschichteten Trägerkorn), chemisches oder elektronisches Ätzen und/oder anodische Oxidation vorbehandelt und in weiteren Schritten mittels Sputtern (Kathodenstrahlzerstäuben) optional zunächst mit einer Haftvermittlerschicht sowie mit einer Konversionsschicht, die Borkarbid oder einen Borfilm umfasst, beschichtet wird.

2. Verfahren nach Anspruch 1, **dadurch gekennzeichnet, dass** das Feinschleifen und/oder Polieren unter Verwendung von Schleifpapieren oder Schleifpasten stattfindet.

3. Verfahren nach Anspruch 2, **dadurch gekennzeichnet, dass** Schleifpapiere oder Schleifpasten der Körnung im Bereich von 800 bis 2500 verwendet werden.

4. Verfahren nach einem der Ansprüche 2 oder 3, **dadurch gekennzeichnet, dass** das Feinschleifen und/oder Polieren zusätzlich unter Verwendung einer Schleifflüssigkeit stattfindet.

5. Verfahren nach Anspruch 4, **dadurch gekennzeichnet, dass** die Schleifflüssigkeit aus der Gruppe bestehend aus Aceton, einem Alkohol und Wasser ausgewählt ist.

6. Verfahren nach Anspruch 5, **dadurch gekennzeichnet, dass** als Alkohol Ethanol verwendet wird.

7. Verfahren nach einem der vorgehenden Ansprüche, **dadurch gekennzeichnet, dass** das neutronentransparente Metallsubstrat aus Aluminium oder einer Aluminiumlegierung besteht.

8. Verfahren nach einem der vorgehenden Ansprüche, **dadurch gekennzeichnet, dass** das neutronentransparente Metallsubstrat aus Aluminium oder einer Titan-Aluminium-Legierung besteht.

9. Verfahren nach einem der vorgehenden Ansprüche, **dadurch gekennzeichnet, dass** mit ¹⁰B angereichertes B₄C als Borkarbid verwendet wird.

10. Verfahren nach Anspruch 9, **dadurch gekennzeichnet, dass** das Borkarbid 20-95%, bevorzugt 40-95%, bevorzugter 60-95% und am bevorzugtesten 95% ¹⁰B umfasst.

11. Verfahren nach einem der vorgehenden Ansprüche, **dadurch gekennzeichnet** , das vorbehandelte Metallsubstrat vor dem Beschichten gespült wird.

12. Verfahren nach einem der vorgehenden Ansprüche, **dadurch gekennzeichnet, dass** das vorbehandelte und gegebenenfalls gespülte Metallsubstrat mit einer Haftvermittlerschicht beschichtet wird.

13. Verfahren nach Anspruch 12, **dadurch gekennzeichnet, dass** die Haftvermittlerschicht aus Titan besteht.

14. Neutronenkonverter, hergestellt nach einem Verfahren gemäß einem der Ansprüche 1 bis 13.

15. Verwendung eines nach dem Verfahren gemäß einem der Ansprüche 1 bis 12 hergestelltes, mit Borkarbid beschichtetes Metallsubstrat als Neutronenkonverter.
